## Europäisches Patentamt

## European Patent Office

## Office européen des brevets

(11) Veröffentlichungsnummer: **0 054 079**
**B1**

(12) **EUROPÄISCHE PATENTSCHRIFT**

(45) Veröffentlichungstag der Patentschrift:
**12.09.84**

(51) Int. Cl.³: **H 03 K 13/175**

(21) Anmeldenummer: **80107811.4**

(22) Anmeldetag: **11.12.80**

(54) **MOS-Parallel-A/D-Wandler.**

(43) Veröffentlichungstag der Anmeldung:
**23.06.82 Patentblatt 82/25**

(45) Bekanntmachung des Hinweises auf die Patenterteilung:
**12.09.84 Patentblatt 84/37**

(84) Benannte Vertragsstaaten:
**DE FR GB IT NL**

(56) Entgegenhaltungen:
FR - A - 2 290 794
US - A - 3 747 089

IEEE JOURNAL OF SOLID-STATE CIRCUITS, Band
SC-14, Nr. 6, Dezember 1979, Seiten 926-932 New York,
US A. DINGWALL: "Monolithic Expandable 6 Bit 20 MHz
CMOS/SOS A/D Converter"

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Flamm, Peter, Ing. grad.,
Stefan-Meier-Strasse 167, D-7800 Freiburg (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

## Beschreibung

Die Erfindung betrifft monolithisch mittels Isolierschicht-Feldeffekttransistoren integrierte Parallel-Analog-Digital-Wandler, also kurz MOS-Parallel-A/D-Wandler.

Nach dem Buch von D.F. Hoeschele «Analog-to-Digital/Digital-to-Analog-Conversion Techniques», New York, 1968, Seiten 10, 249, 253 bis 259 und 409 bis 412 bestehen derartige MOS-Parallel-A/D-Wandler aus $p=2^n-1$ Komparatoren, einem aus p oder $p-1$ Widerständen bestehenden und an einer Referenzspannung liegenden Spannungsteiler und einem mit den Ausgängen der Komparatoren verbundenen Decoderteil. Mit n ist dabei die Anzahl der Binärstellen des digitalen Wandler-Ausgangssignals bezeichnet. Alle Komparatoreingänge der einen Art, also beispielsweise die nichtinvertierenden, sind mit dem Signaleingang und die Komparatoreingänge der anderen Art, also beispielsweise die invertierenden, mit je einem Spannungsteilerabgriff verbunden.

Bei der Realisierung derartiger Parallel-Analog-Digital-Wandler in MOS-Technik machen sich die Unterschiede der Offsetspannungen der einzelnen Komparatoren nachteilig bemerkbar, die wesentlich kleiner sein müssen als der zum niederstwertigen Bit gehörende Spannungsschritt, der im allgemeinen gleich dem Spannungsabfall an einem der Spannungsteilerwiderstände ist. Zur zahlenmässigen Veranschaulichung dieses Problems sei angenommen, dass ein 7-Bit-Wandler, der somit 127 Komparatoren hat, und dessen Spannungsteiler an einer Referenzspannung von 5 V betrieben wird, so dass der erwähnte Spannungsschritt etwa 40 mV beträgt. Dann dürfen die Unterschiede der Offsetspannungen maximal etwa $\pm 2,5$ mV betragen. Derart kleine Offsetspannungsdifferenzen lassen sich jedoch, wenn überhaupt, nur schwierig realisieren.

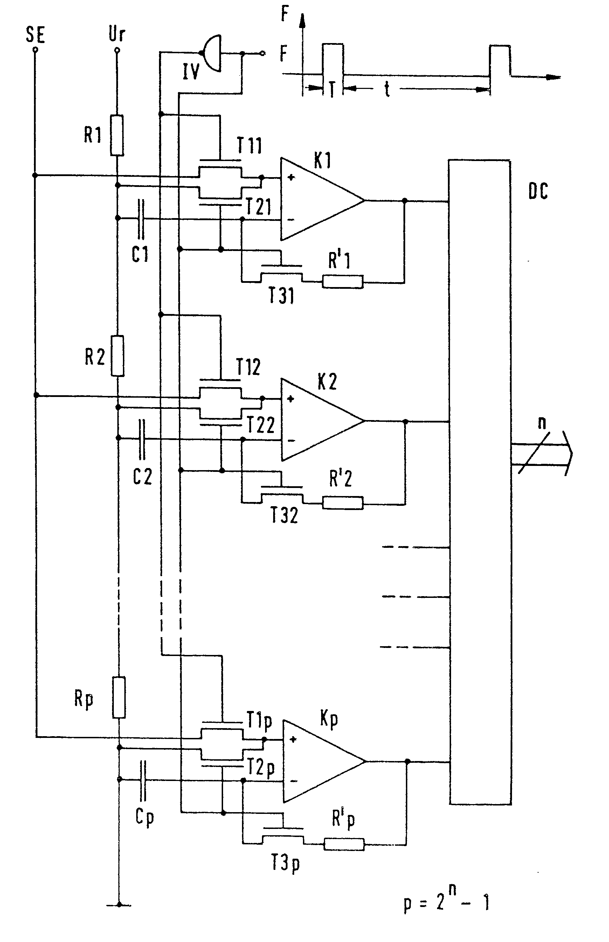

Aus der Zeitschrift «IEEE Journal of Solid-State Circuits», 1979, Seiten 926 bis 932, insbesondere Fig. 2 und 3 auf Seiten 927/928, ist dieses Problem bei einer allerdings in CMOS-Technik unter anderem mittels CMOS-Transmission-Gates realisierten Anordnung entsprechend dem Oberbegriff des Patentanspruchs bekannt. Bei dieser Anordnung ist jeweils ein Transistor des CMOS-Transmission-Gate-Transistorpaars mit dem jeweiligen Transfertransistor der Erfindung vergleichbar. Da zum Sperren und Öffnen von CMOS-Transmission-Gates bekanntlich zwei nichtüberlappende Taktsignale erforderlich sind, ist bei der bekannten Anordnung vorgesehen, dass während der ersten Taktperiodenhälfte der jeweilige Spannungsteilerabgriff mittels des einen CMOS-Transmission-Gates über die zugeordnete Kapazität am entsprechenden Komparatoreingang liegt, während zugleich der Komparator, der lediglich ein CMOS-Inverter ist, über ein weiteres CMOS-Transmission-Gate auf seinen Kippunkt normiert wird. Während der zweiten Taktperiodenhälfte liegt dagegen der Komparatoreingang über ein leitend gesteuertes drittes CMOS-Transmission-Gate am Spannungsteiler, während der CMOS-Inverter in seinem Kippunkt freigegeben ist.

Die im Anspruch angegebene Erfindung gibt eine weitere Lösung des Problems der dynamischen Kompensierung von MOS-Parallel-A/D-Wandlern an.

Die Erfindung wird nun anhand der Zeichnung näher erläutert, die ein schematisches Schaltbild eines bevorzugten Ausführungsbeispiels blockschaltbildmässig zeigt. Entsprechend der Anzahl n der Binärstellen des Wandler-Ausgangssignals, das am Ausgang des Codierteils DC abnehmbar ist, sind $p=2^n-1$ Komparatoren K1, K2, Kp vorhanden, die beispielsweise aus Operationsverstärkern oder Differenzverstärkern bestehen können und deren Ausgänge mit dem Paralleleingang des Codierteils DC verbunden sind.

Jeder nichtinvertierende Eingang + der Komparatoren K1... Kp liegt über dem gesteuerten Strompfad des ersten Transfertransistors T11, T12, T1p am Signaleingang SE. Ferner liegt der nichtinvertierende Eingang über den gesteuerten Strompfad des zweiten Transfertransistors T21, T22, T2p am zugehörigen Spannungsteilerabgriff. Dieser Spannungsteiler besteht aus den Widerständen R1, R2, Rp und liegt an der Referenzspannung Ur. In der Zeichnung liegt somit der zweite Transistor T21 am Verbindungspunkt der Widerstände R1, R2, der zweite Transistor T22 am Verbindungspunkt des Widerstandes R2 mit dem in der Zeichnung nicht mehr gezeigten nächsten Spannungsteilerwiderstand und der zweite Transistor T2p am Verbindungspunkt des letzten Widerstands Rp des Spannungsteilers mit dem Schaltungsnullpunkt.

An den eben erwähnten Spannungsteilerabgriffen liegt auch jeweils die Kapazität C1, C2, Cp, deren anderes Ende am invertierenden Eingang des zugehörigen Komparators K1, K2, Kp liegt. Zur Realisierung dieser Kapazitäten werden vorteilhafterweise MOS-Kondensatoren herangezogen, die dann in die integrierte Schaltung miteinbezogen sind. Es ist jedoch auch möglich, diese Kapazitäten mittels anderer oder von aussen an die integrierte Schaltung anzuschaltender Kondensatoren zu realisieren.

Vom Ausgang jeden Komparators K1, K2, Kp führt ein Gegenkopplungspfad zum zugehörigen invertierenden Eingang, der aus dem Widerstand R'1, R'2, R'p und dem damit in Serie liegenden gesteuerten Strompfad des jeweiligen dritten Transfertransistors T31, T32, T3p besteht. Das eine Ende des gesteuerten Strompfades des jeweiligen dritten Transfertransistors liegt somit auch am einen Anschluss der entsprechenden Kapazität C1, C2, Cp.

Die Gates der zum jeweiligen Komparator K1, K2, Kp gehörenden zweiten und dritten Transfertransistoren T21, T31; T22, T32; T2p, T3p sind miteinander verbunden und liegen an einem sie nur während der Zeichenrücklaufimpulse als kurze Wandlungspausen T leitend steuernden Taksignal F, dessen zeitlicher Verlauf in der Zeichnung rechts oben schematisch angedeutet ist und das über den Inverter IV invertiert auch die Gates der ersten Transfertransistoren T11, T12, T1p ansteuert. Die

kurzen Wandlungspausen T können auch als Kompensationszeiten bezeichnet werden, da während ihnen die dynamische Kompensation wirksam ist.

Während der Wandlungspausen T sind somit die zweiten und dritten Transfertransistoren leitend und die ersten Transfertransistoren gesperrt, wobei für das Ausführungsbeispiel der Zeichnung vorausgesetzt ist, dass die darin gezeigten Transistoren p-Kanal-Transistoren vom Anreicherungstyp sind. Über den jeweiligen Widerstand R'1, R'2, R'p wird somit die Spannung am jeweiligen invertierenden Eingang der Komparatoren K1, K2, Kp auf den Spannungswert am zugehörigen Spannungsteilerabgriff inkl. der jeweiligen Offsetspannung der Komparatoren eingestellt, da über die zweiten Transfertransistoren der nichtinvertierende Eingang an diesen Potentialpunkt gelegt ist, der sonst jedoch am Signaleingang SE liegt. Somit ist die jeweilige Kapazität C1, C2, Cp auf die Offsetspannung des zugehörigen Komparators aufgeladen.

Während der Zeilenhinlaufimpulse als Wandlungszeiten t, also der Zeiten, während denen analog-digital-gewandelt wird, sind die zweiten und dritten Transfertransistoren gesperrt und die ersten Transfertransistoren leitend, so dass das Eingangssignal zum nichtinvertierenden Eingang durchgeschaltet und der invertierende Eingang auf dem Potential des Spannungsteilerabgriffs inkl. der jeweiligen Offsetspannung festgehalten ist, so dass die Kapazitäten C1... Cp während der Wandlungszeiten t eine Kompensationsspannungsquelle für die zugehörigen Komparatoren K1... Kp bilden.

Eine überschlägige Rechnung für die bevorzugte Anwendung in Fernsehern mit den oben bereits genannten Zahlenwerten ergibt für einen 7-Bit-Parallel-A/D-Wandler bei einer Wandlungszeit von $t \approx 60\,\mu s$ und einer während dieser Zeit zugelassenen Spannungsänderung an der jeweiligen Kapazität von $dU \approx 0{,}25\,mV$, was etwa 10% des dem niederstwertigen Bit zugeordneten Teils der Referenzspannung entspricht, sowie einer Leckstromsumme des jeweiligen Komparatoreingangstransistors und des dritten Transfertransistors $I_L \approx 10\,pA$ folgenden Kapazitätswert:

$$C = \frac{t}{dU} I_L \approx 2{,}5\,pF.$$

Kapazitäten in dieser Grössenordnung lassen sich ohne weiteres in MOS-Technik als sogenannte MOS-Kondensatoren mit vertretbarem Flächenaufwand realisieren.

## Patentanspruch

Monolithisch mittels Isolierschicht-Feldeffekttransistoren integrierter Parallel-Analog-Digital-Wandler zur Verwendung in Fernsehgeräten (MOS-Parallel-A/D-Wandler) mit einem Signaleingang (SE), $p=2^n-1$ Komparatoren (K1, K2, Kp), einem an einer Referenzspannung (Ur) liegenden, aus p oder p−1 Widerständen (R1, R2, Rp) bestehenden Spannungsteiler und einem mit den Ausgängen der Komparatoren verbundenen Codierteil (DC), wobei

— mit n die Anzahl der Binärstellen des digitalen Wandlerausgangssignals bezeichnet ist,

— alle Komparatoren eingangsseitig mit dem Signaleingang (SE) über den gesteuerten Strompfad eines ersten Transfertransistors (T11, T12, T1p) sowie mit je einem Spannungsteilerabgriff über den gesteuerten Strompfad eines zweiten Transfertransistors (T21, T22, T2p) verbunden sind,

— jeder Komparatorausgang über einen Widerstand (R'1, R'2, R'p) und den gesteuerten Strompfad eines damit in Reihe liegenden dritten Transfertransistors (T31, T32, T3p) an einem Komparatoreingang liegt, der mit einer Kapazität (C1, C2, Cp) verbunden ist, und

— die Gates des zweiten und des dritten Transfertransistors (T21, T31; T22, T32; T2p, T3p) miteinander verbunden sind und an einem sie leitend steuernden Taktsignal (F) sowie die Gates der ersten Transfertransistoren (T11, T12, T1p) am invertierten Taktsignal liegen, gekennzeichnet durch folgende Merkmale:

— jeder Komparator besitzt einen nicht invertierenden, mit dem Signaleingang (SE) verbundenen und einen invertierenden, mit der Kapazität (C1, C2, Cp) verbundenen Eingang,

— jeder invertierende Komparatoreingang (−) liegt über der Kapazität (C1, C2, Cp) am zugehörigen Spannungsteilerabgriff, und

— das Taktsignal (F) steuert die zweiten und dritten Transfertransistoren (T21, T31; T22, T32; T2p, T3p) nur während der Dauer des Zeilenrücklaufs leitend.

## Claim

Monolithic integrated parallel analog-to-digital converter (MOS parallel A/D converter) employing insulated-gate field-effect transistors for the use in television receivers, comprising a signal input (SE), $p=2^n-1$ comparators (K1, K2, Kp), a voltage divider applied to a reference voltage (Ur), consisting of p or p−1 resistors (R1, R2, Rp) and a coder part (DC) connected to the outputs of said comparators,

— where n is indicative of the number of binary positions of the digital converter output signal,

— wherein all comparators are input-sided connected to the signal input (SE) via the controlled current path of a first transfer transistor (T11, T12, T1p) and to one voltage divider tap each via the controlled current path of a second transfer transistor (T21, T22, T2p),

— wherein each comparator output is applied across a resistor (R'1, R'2, R'p) and via the controlled current path of a third transfer transistor (T31, T32, T3p) as arranged in series therewith, to that comparator input, which is connected to a capacitor (C1, C2, Cp), and

— wherein the gates of the second and of the third transfer transistor (T21, T31; T22, T32; T2p, T3p) are connected with each other and are applied to a clock signal (F) and the gates of said first transfer transistors (T11, T12, T1p) are applied to the inverted clock signal, characterized by the following features:

— each comparator has a non-inverting input being connected to the signal input (SE), and an inverting input connected to the capacitor (C1, C2, Cp),

— each inverting comparator input (−) is applied via the capacitor (C1, C2, Cp) to the associated voltage divider tap, and

— the clock signal renders conductive the second and the third transfer transistors (T21, T31; T22, T32; T2p, T3p) only during the line fly-back period.

## Revendication

Convertisseur analogique/numérique parallèle monolithique intégré, du type à transistors à effet de champ à grille isolée (convertisseur A/D MOS parallèle), pour utilisation dans des appareils de télévision, comportant une entrée de signal (SE), des comparateurs (K1, K2, Kp) en nombre $p=2^n-1$, un diviseur de tension constitué de p ou p−1 résistances (R1, R2, Rp) connecté à une tension de référence (Ur), et une partie codeur (DC) reliée aux sorties des comparateurs, ces éléments étant tels que

— n désigne le nombre des emplacements binaires du signal de sortie numérique du convertisseur,

— tous les comparateurs sont reliés, côté entrée, à l'entrée de signal (SE) par l'intermédiaire du trajet de conduction commandé d'un premier transistor de transfert (T11, T12, T1p), ainsi que chacun à une prise d'un diviseur de tension, cela par l'intermédiaire du trajet de conduction commandé d'un deuxième transistor de transfert (T21, T22, T2p),

— par l'intermédiaire d'une résistance (R'1, R'2, R'p) et du trajet de conduction commandé d'un troisième transistor de transfert (T31, T32, T3p) monté en série avec cette résistance, chaque sortie de comparateur est connectée à une entrée de comparateur, laquelle est reliée à une capacité (C1, C2, Cp), et

— les grilles des deuxième et troisième transistors de transfert (T21, T31; T22, T32; T2p, T3p) sont mutuellement reliées et reçoivent un signal d'horloge (F) qui en commande la conduction, et les portes des premiers transistors de transfert (T11, T12, T1p) sont aussi reliées entre elles et reçoivent le signal d'horloge inversé, ce convertisseur étant caractérisé par les particularités suivantes:

— chaque comparateur possède une entrée non inverseuse reliée à l'entrée de signal (SE), et une entrée inverseuse reliée à la capacité (C1, C2, Cp),

— chaque entrée inverseuse (−) du comparateur est connectée par l'intermédiaire de la capacité (C1, C2, Cp), à la prise correspondante du diviseur de tension, et

— le signal d'horloge (F) ne commande les deuxièmes et troisièmes transistors de transfert (T21, T31; T22, T32; T2p, T3p) que pendant la durée du retour de ligne.

$$p = 2^n - 1$$